# EUROPEAN PATENT APPLICATION

(11) **EP 4 807 781 A1**
(43) Date of publication of application: **16.09.2026**
(21) Application number: 24902664.2
(22) Date of filing: 04.12.2024
(51) Int. Cl.: H01J 37/32, H01L 21/67

(54) **ELECTRON BEAM GENERATOR AND ION BEAM ETCHING DEVICE**

(30) Priority: 12.12.2023 CN 202311704354
(71) Applicant: Beijing NAURA Microelectronics Equipment Co., Ltd., Beijing 100176 (CN)
(72) Inventor: TIAN, Jia, Beijing 100176 (CN)
(74) Representative: Cohausz & Florack
(86) International application number: PCT/CN2024/136615
(87) International publication number: WO 2025/124243

(57) **Abstract**

The present disclosure provides an electron beam generator and ion beam etching equipment. The electron beam generator includes: an electron beam generation chamber having an extraction opening; and a shielding assembly movably disposed outside the electron beam generation chamber. The shielding assembly is configured to shield the extraction opening, and is able to adjust an extraction area of the extraction opening by adjusting a position of the shielding assembly. In the present disclosure, the extraction area of the extraction opening is adjusted through the shielding assembly according to a magnitude of a plasma density value inside the electron beam generation chamber, so that the extraction area is able to adapt to a plasma sheath morphology change, and electron extraction efficiency is always maintained at a relatively large value, thereby effectively improving performance and stability of the electron beam generator.

## Description

### TECHNICAL FIELD

The present disclosure relates to the field of semiconductor manufacturing, and specifically, to an electron beam generator and ion beam etching equipment.

### BACKGROUND

With the development of micro-nano fabrication technology, the requirements for etching technology are becoming increasingly stringent. At present, etching can be broadly categorized into wet etching and dry etching. Dry etching mostly utilizes radio frequency coupling to generate a plasma source, including inductively coupled plasma (ICP) and capacitively coupled plasma (CCP), and then uses ions or free radicals from the plasma source to perform the desired etching process. Compared to wet etching, dry etching offers higher etching precision, greater controllability, and better anisotropy, thus attracting increasing attention.

For dry etching systems, in addition to the ion source, the electron source also plays a crucial role. For example, in high-vacuum etching systems (e.g., pressures below 10⁻⁵ Torr), successful ignition becomes one of the challenges affecting system stability due to the scarcity of seed electrons. One method to improve the startup stability of RF systems is to increase the number of seed electrons. Furthermore, in ion beam etching systems, to reduce the repulsive forces between ions, improve the uniformity of the ion beam current, reduce charge accumulation on the wafer surface, and increase the etching rate, a sufficient electron beam current is needed to neutralize the extracted ion beam before the etching process. Both of these aspects need a high-density, stable output electron beam current.

Electron beam generators that produce electron beams include, for example, ICP electron beam generators. ICP electron beam generators are high-performance electron beam current generation devices. Compared to other types of electron beam generators, ICP electron beam generators have a wider range of applicable process scenarios and a longer lifespan. Therefore, they have received increasing attention in recent years. The working principle of an ICP electron beam generator is as follows: plasma is generated through inductive coupling. Under the influence of a spatial electric field, positive ions move towards the negatively charged ion collecting electrode (cathode), while electrons are extracted from the extraction port. The balance between these two processes maintains the stability of the ICP electron beam generator's operation.

However, existing electron beam generators suffer from low electron extraction performance and efficiency.

### SUMMARY

The present disclosure aims to solve at least one of the technical problems existing in the prior art, and proposes an electron beam generator and ion beam etching equipment, which can mitigate the problem of low electron extraction performance and efficiency existing in the electron beam generator in the prior art.

To achieve the objective of the present disclosure, an electron beam generator is provided, including:
an electron beam generation chamber, having an extraction opening;
A shielding assembly, movably disposed outside the electron beam generation chamber, the shielding assembly being configured to shield the extraction opening, and an extraction area of the extraction opening being able to be adjusted by adjusting a position of the shielding assembly.

In some embodiments, the shielding assembly includes a plurality of shielding plates arranged in sequence in a circumferential direction, inner peripheral surfaces of the plurality of shielding plates collectively form an extraction control opening, and the extraction control opening is disposed corresponding to the extraction opening;
The plurality of shielding plates are all able to move along a radial direction of the extraction control opening, and collectively form the extraction control opening with different opening areas at different positions in the radial direction of the extraction control opening

In some embodiments, the extraction control opening is coaxial with the extraction opening.

In some embodiments, the electron beam generator further includes a mounting member, the mounting member is provided with guide grooves, the shielding plates are correspondingly disposed in the guide grooves, and each of the guide grooves is configured to enable a corresponding shielding plate to move along the radial direction of the extraction control opening.

In some embodiments, a cutout part communicating with the guide groove is further formed at the mounting member, and an orthographic projection of the cutout part on a radial cross-section of the extraction opening at least partially overlaps with an orthographic projection of the extraction opening on the radial cross-section of the extraction opening;
The shielding plate is able to extend into the cutout part along the radial direction of the extraction control opening.

In some embodiments, the mounting member is an annular mounting member, and an annular hole of the annular mounting member is coaxially arranged with the extraction opening;
Each of the guide grooves has an opening formed at an inner peripheral surface of the annular mounting member; each of the shielding plates is able to extend into the annular hole via the opening along the radial direction of the extraction control opening, and the inner peripheral surface of each of the shielding plates and the opening both face toward the annular hole.

In some embodiments, an orthographic projection of a portion of each shielding plate extending into the cutout part on the radial cross-section of the extraction opening partially overlaps with orthographic projections of portions of two adjacent shielding plates extending into the cutout part on the radial cross-section of the extraction opening.

In some embodiments, overlapping portions of each shielding plate and two adjacent shielding plates are respectively located at different sides of the two adjacent shielding plates.

On a side surface of each of the guide grooves corresponding to the cutout part, a movement channel penetrating along the radial direction of the extraction control opening to an outer side surface of the mounting member facing away from the side surface is formed;
The electron beam generator further includes a plurality of connection rods and a plurality of linear driving sources, each of the connection rods is disposed through each of the movement channels in a one-to-one correspondence, and one end of each of the connection rods is connected to each of the shielding plates in a one-to-one correspondence, and another end is connected to each of the linear driving sources in a one-to-one correspondence; each of the linear driving sources is configured to drive a corresponding shielding plate to move along the radial direction of the extraction control opening through a corresponding connection rod.

In some embodiments, the electron beam generator further includes an annular fixing member, and the annular fixing member is fixedly connected to the annular mounting member and configured to limit each of the shielding plates in a corresponding guide groove.

In some embodiments, a positioning structure is disposed between the annular fixing member and the annular mounting member, and configured to define a relative position between the annular fixing member and the annular mounting member.

In some embodiments, the positioning structure includes a protrusion structure formed at a surface of the annular mounting member where the guide grooves are located, and the protrusion structure forms a positioning groove on the annular mounting member, and configured to define the relative position of the annular fixing member on the annular mounting member.

In some embodiments, the protrusion structure includes an annular protrusion disposed along an outer peripheral edge of the surface of the annular mounting member where the guide grooves are located, and a convex block disposed at an inner peripheral edge of the surface of the annular mounting member where the guide grooves are located and located between every two adjacent guide grooves, an inner peripheral surface of the annular protrusion is fitted with an outer peripheral surface of the annular fixing member; and a surface of the convex block corresponding to the annular protrusion is fitted with an inner peripheral surface of the annular fixing member.

In some embodiments, the electron beam generator further includes a plurality of limit rods;
a plurality of limit channels are formed at a surface of the annular fixing member facing the annular mounting member, each of the limit channels extends along the radial direction of the extraction control opening, and a channel opening is formed at an inner peripheral surface of the annular fixing member; each of the limit rods is disposed in each of the limit channels in a one-to-one correspondence, and is able to extend into an annular hole of the annular fixing member via the channel opening along the radial direction of the extraction control opening;
each of the limit rods is stacked on a surface of each of the shielding plates adjacent to the annular fixing member in a one-to-one correspondence, and an end of each of the limit rods facing the channel opening is fixedly connected to an inner peripheral edge of a corresponding shielding plate.

In some embodiments, an end of each limit rod facing the channel opening is provided with a bent member bent in a direction approaching the shielding plate; a fixing hole is formed at an inner peripheral edge of the surface of each shielding plate adjacent to the annular fixing member;
the bent member of each of the limit rods is disposed in the fixing hole of each of the corresponding shielding plates.

As another technical solution, the present disclosure further provides ion beam etching equipment, including a process chamber, and an ion source generation device and a carrier device oppositely disposed in the process chamber along a first direction, and further including the above electron beam generator provided by the present disclosure, the electron beam generator is disposed at a chamber body of the process chamber, and the extraction opening communicates with the process chamber and faces toward a second direction, and configured to extract an electron beam into the process chamber, where the second direction is at an angle with the first direction.

In some embodiments, a sensor and a controller are further included, the sensor is configured to obtain a plasma density in the electron beam generation chamber, and the controller is configured to, according to the plasma density obtained by the sensor, control the shielding assembly in the electron beam generator to adjust the extraction area of the extraction opening.

The present disclosure has following beneficial effects:
The electron beam generator provided by the present disclosure can adjust an extraction area of an extraction opening of an electron beam generation chamber through a shielding assembly. Since extraction performance and efficiency of an electron beam are closely related to a plasma sheath morphology on a surface of the extraction opening, and the plasma sheath morphology on the surface of the extraction opening is in turn closely related to a plasma density generated inside the electron beam generation chamber, in view of this, since an extraction area of an extraction opening in related technology is fixed, it can only adapt to one operating condition of an electron beam generator, i.e., a certain plasma density inside an electron beam generation chamber and a corresponding plasma sheath morphology on a surface of the extraction opening. Under the circumstance that the operating condition does not change, the extraction area of the extraction opening can achieve optimal extraction performance and efficiency. However, when the operating condition changes, i.e., the plasma density inside the electron beam generation chamber changes, the plasma sheath morphology also changes correspondingly; at this time, the fixed extraction area cannot adapt to the plasma sheath morphology change, and thus cannot cause electron extraction efficiency to be always maintained at a relatively large value. In view of this, the solution of the present disclosure, during a process of electron movement, by controlling the shielding assembly to adjust the extraction area of the extraction opening according to a magnitude of a plasma density value inside the electron beam generation chamber, can cause the extraction area to be able to adapt to the plasma sheath morphology change, so that the electron extraction efficiency is always maintained at a relatively large value, thereby effectively improving performance and stability of the electron beam generator.

The ion beam etching equipment provided in the present disclosure can maintain the electro extraction efficiency always at a relatively large value by using above electron beam generator provided in the present disclosure, thus can optimize the process performance.

### BRIEF DESCRIPTION OF THE DRAWINGS

FIG. 1 is a sectional view of an electron beam generator provided by embodiments of the present disclosure;
FIG. 2 is a position relationship diagram of a shielding assembly and an electron beam generation chamber adopted by embodiments of the present disclosure;
FIG. 3A is a perspective structural view of another shielding assembly adopted by embodiments of the present disclosure from one perspective;
FIG. 3B is a perspective structural view of another shielding assembly adopted by embodiments of the present disclosure from another perspective;
FIG. 4 is a perspective sectional view of another shielding assembly adopted by embodiments of the present disclosure;
FIG. 5A is a perspective sectional view of an annular mounting member adopted by embodiments of the present disclosure from one perspective;
FIG. 5B is a perspective sectional view of an annular mounting member adopted by embodiments of the present disclosure from another perspective;
FIG. 6 is an exploded view of an annular mounting member and a shielding assembly adopted by embodiments of the present disclosure;
FIG. 7 is a perspective view of an annular fixing member adopted by embodiments of the present disclosure;
FIG. 8 is a structure and distribution diagram of a limit rod adopted by embodiments of the present disclosure;
FIG. 9 is an exploded view of an annular mounting member, a shielding assembly, and an annular fixing member adopted by embodiments of the present disclosure;
FIG. 10 is an assembly view of an annular mounting member, a shielding assembly, and an annular fixing member adopted by embodiments of the present disclosure;
FIG. 11 is a schematic structural view of ion beam etching equipment provided by embodiments of the present disclosure.

### DETAILED DESCRIPTION OF THE EMBODIMENTS

In order to enable those skilled in the art to better understand technical solutions of the present disclosure, an electron beam generator and ion beam etching equipment provided by the present disclosure are described in detail below in conjunction with the accompanying drawings.

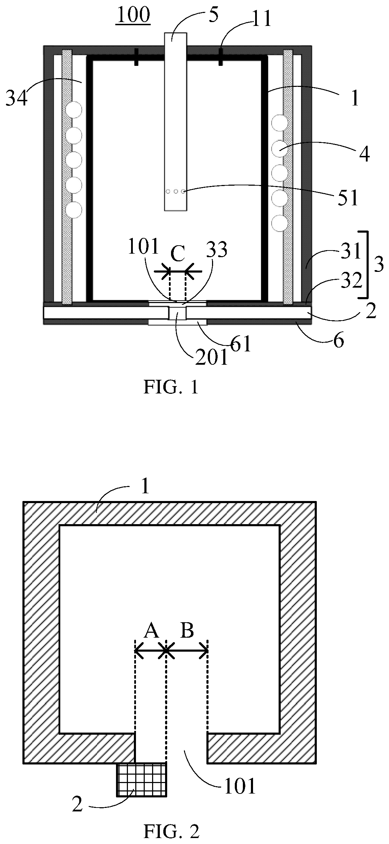

Please refer to FIG. 1, embodiments of the present disclosure provide an electron beam generator 100, including an electron beam generation chamber 1 having an extraction opening 101. In some embodiments, the electron beam generator 100 further includes an extraction electrode 6, a shielding chamber 3, an RF coil 4, and an ion collector 5. The electron beam generation chamber 1 has the above extraction opening 101, and electrons in the electron beam generation chamber 1 are able to move from the extraction opening 101 to the outside of the electron beam generation chamber 1. The extraction opening 101 may specifically be a through hole disposed in a chamber wall (for example, a lower chamber wall) of the electron beam generation chamber 1, and the through hole may be a straight through hole, or may also be a variable diameter hole, such as a tapered hole, and a diameter of the tapered hole increases along a movement direction of the electrons.

The extraction electrode 6 is disposed outside the electron beam generation chamber 1 and is located at a side where the extraction opening 101 is located at an interval. The extraction electrode 6 has a first extraction opening 61, the first extraction opening 61 is disposed corresponding to the extraction opening 101, and the first extraction opening 61 is greater than or equal to the extraction opening 101, and used to play a guiding role for the movement of the electrons. The above electron beam generation chamber 1 is disposed inside the shielding chamber 3, and specifically may be fixed to an upper chamber wall of the shielding chamber 3 through fasteners 11. The shielding chamber 3 is configured to shield an electric field in the electron beam generation chamber 1 to avoid generating interference to external parts. A second extraction opening 33 used for allowing electrons to pass through is disposed at the chamber wall of the shielding chamber 3 adjacent to the extraction opening 101. The second extraction opening 33 is disposed corresponding to the extraction opening 101 (for example, coaxially arranged), and the second extraction opening 33 is greater than or equal to the extraction opening 101 to avoid affecting the movement of the electrons. Specifically, the shielding chamber 3 includes a shielding chamber main body 31 with one end open and a shielding chamber lid body 32 sealingly connected to the shielding chamber main body 31, the shielding chamber lid body 32 is stacked on an outer surface of the chamber wall where the second extraction opening 33 of the electron beam generation chamber 1 is located, and used to seal the open end of the shielding chamber main body 31, and the above second extraction opening 33 is, for example, a through hole disposed in the shielding chamber lid body 32.

A circumferential annular space 34 is provided between an inner surface of the shielding chamber 3 and an outer surface of the electron beam generation chamber 1, and the annular space 34 is, for example, collectively formed by an inner peripheral surface of the shielding chamber main body 31, an outer peripheral surface of the electron beam generation chamber 1, an inner surface of an upper chamber wall of the shielding chamber main body 31, and an inner surface of the shielding chamber lid body 32. An RF coil 4 is disposed in the above annular space 34 and surrounds the electron beam generation chamber 1, the RF coil 4 is configured to be electrically connected to an RF source, the RF source, for example, includes an RF power supply and an impedance matcher, and the RF power supply is electrically connected to the RF coil 4 through the impedance matcher, and used to load RF power to the RF coil 4 to excite gas (for example, inert gas) in the electron beam generation chamber 1 to form plasma.

One end of the ion collector 5 sequentially penetrates through a shielding chamber 3 and an electron beam generation chamber 1 from a side of the shielding chamber 3 away from the second extraction opening 33 (for example, an upper side of the shielding chamber 3), and extends into an interior of the electron beam generation chamber 1. An intake channel used for connecting to a gas source is disposed in the ion collector 5, and an intake port 51 of the intake channel communicates with the interior of the electron beam generation chamber 1, and used to introduce gas (for example, inert gas) into the interior of the electron beam generation chamber 1. In some embodiments, the ion collector 5 is tubular, an internal space of a tube is the above intake channel, there are a plurality of the above intake ports 51, and the intake ports 51 are uniformly distributed in a tube wall along a circumferential direction. The intake port 51 is, for example, a through hole penetrating the tube wall in a radial direction.

When an electron beam generator 100 operates, inert gas is introduced into an interior of an electron beam generation chamber 1 through an ion collector 5, and an RF source is turned on to load RF power to an RF coil 4, so as to excite the inert gas inside the electron beam generation chamber 1 to form plasma. Moreover, the ion collector 5 has a negative potential, and an extraction electrode 6 has a positive potential, and a space electric field is formed between the ion collector 5 and the extraction electrode 6. Positive ions in the plasma move toward the ion collector 5 with the negative potential, while electrons in the plasma move toward the extraction electrode 6 with the positive potential, and move from an extraction opening 101 to the outside of the electron beam generation chamber 1.

The inventors found that: extraction performance and efficiency of an electron beam are closely related to a plasma sheath morphology on a surface of an extraction opening 101, and the plasma sheath morphology on the surface of the extraction opening 101 is in turn closely related to a plasma density generated inside an electron beam generation chamber 1. Thus, since an extraction area of the extraction opening 101 in related technology is fixed and can only adapt to one operating condition of an electron beam generator, i.e., a certain plasma density inside an electron beam generation chamber and a corresponding plasma sheath morphology on the surface of the extraction opening 101, under this circumstance that the operating condition does not change, the above fixed extraction area of the extraction opening 101 can achieve optimal extraction performance and efficiency. That is, one extraction area of the extraction opening 101 can only be an optimal size that causes electron extraction efficiency to be maintained at a relatively large value under a certain operating condition. However, when the operating condition changes, i.e., the plasma density inside the electron beam generation chamber changes, the plasma sheath morphology also changes correspondingly. At this time, the fixed extraction area cannot adapt to the plasma sheath morphology change, and thus cannot cause electron extraction efficiency to be always maintained at a relatively large value, resulting in a decrease in the extraction performance and efficiency of the electron beam.

To solve the above problems, an electron beam generator provided by embodiments of the present disclosure further includes a shielding assembly 2, and the shielding assembly 2 is configured to adjust an extraction area of an extraction opening 101. Specifically, the shielding assembly 2 is, for example, disposed outside an electron beam generation chamber 1 and located at a side where the extraction opening 101 is located, for example, disposed between the electron beam generation chamber 1 and an extraction electrode 6. In a case where a shielding chamber 3 is provided, as shown in FIG. 1, the shielding assembly 2 may also be disposed between the shielding chamber 3 and the extraction electrode 6.

The shielding assembly 2 is configured to adjust the extraction area of the extraction opening 101. The so-called extraction area of the extraction opening 101 refers to a radial cross-sectional area of an opening through which electrons are able to pass. During a process of electron movement, by controlling the electron beam generator 100 to adjust the extraction area of the extraction opening 101 according to a magnitude of a plasma density value inside the electron beam generation chamber 1, the extraction area can be enabled to adapt to a plasma sheath morphology change, so that electron extraction efficiency is always maintained at a relatively large value, thereby effectively improving performance and stability of the electron beam generator.

There may be a variety of ways for the above shielding assembly 2 to adjust the extraction area of the extraction opening 101. For example, as shown in FIG. 2, the shielding assembly 2 is movably disposed outside the electron beam generation chamber 1, for example, disposed outside the electron beam generation chamber 1 at a side where the extraction opening 101 is located. The shielding assembly 2 is set to shield the extraction opening 101, and is able to adjust the extraction area of the extraction opening 101 by adjusting a position of the shielding assembly 2. That is, by adjusting the position of the shielding assembly 2, an area of the extraction opening 101 shielded by the shielding assembly 2 can be adjusted to realize adjustment of the extraction area of the extraction opening 101; that is, adjusting the shielding assembly 2 can shield a partial region A of the extraction opening 101, and an opening area of an unshielded region B of the extraction opening 101 is the extraction area of the extraction opening 101. It is easy to understand that the opening area of the extraction opening 101 itself is fixed, and as the position of the shielding assembly 2 changes, an area of the shielded partial region A of the extraction opening 101 changes correspondingly, and at the same time, an area of the unshielded region B of the extraction opening 101 also changes correspondingly, and the area of the region B is the extraction area of the extraction opening 101. There may be multiple movement modes of the shielding assembly 2, for example, the shielding assembly 2 may translate and/or rotate in a plane parallel to a radial direction of the extraction opening 101, and the present disclosure does not limit on this.

The above shielding assembly 2 shown in FIG. 2 does not have an opening itself, and relies on its own structure to shield a partial region of the extraction opening 101 to adjust the extraction area of the extraction opening 101; however, the present disclosure is not limited thereto. In some other embodiments, for example, as shown in FIG. 1, the shielding assembly 2 may also itself have an extraction control opening 201, and the extraction control opening 201 is disposed corresponding to the extraction opening 101. The shielding assembly 2 is set to be able to adjust an opening area of the extraction control opening 201, that is, adjust an area of a region of the extraction opening 101 corresponding to the extraction control opening 201 (i.e., region C in FIG. 1), so as to realize adjustment of the extraction area of the extraction opening 101. It is easy to understand that the shielding assembly 2 can shield regions of the extraction opening 101 other than region C in FIG. 1.

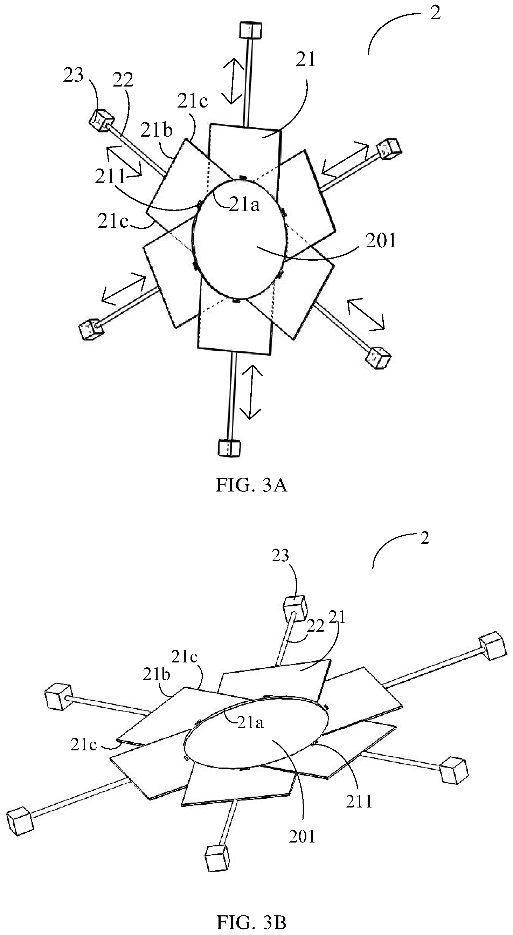

The shielding assembly 2 implementing the above functions may have various structures. For example, as shown in FIG. 3A and FIG. 3B, the shielding assembly 2 includes a plurality of shielding plates 21 arranged in sequence in a circumferential direction, and inner peripheral surfaces 21a of the plurality of shielding plates 21 collectively form an extraction control opening 201. In some embodiments, the extraction control opening 201 is coaxial with the extraction opening 101, which is beneficial for improving extraction performance and efficiency of an electron beam. The plurality of shielding plates 21 are all able to move along a radial direction of the extraction control opening 201 (i.e., an arrow direction in FIG. 3A), and collectively form the extraction control opening 201 with different opening areas at different positions in the radial direction of the extraction control opening 201. In some embodiments, the inner peripheral surfaces 21a of the plurality of shielding plates 21 are all arcuate surfaces, and collectively form a circular extraction control opening 201. Of course, in practical applications, according to different needs, the inner peripheral surfaces 21a of the plurality of shielding plates 21 may also be flat surfaces or surfaces of other shapes, so as to collectively form extraction control openings 201 of different shapes.

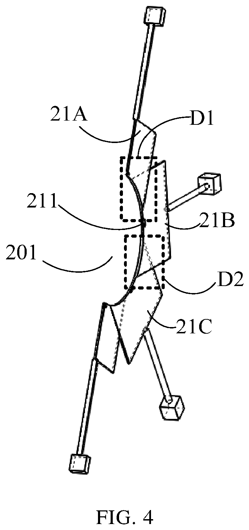

Specifically, the above shielding plate 21 is, for example, a flat plate having four side surfaces, one of the side surfaces is the above inner peripheral surface 21a, for example, an arcuate surface, and remaining three side surfaces are all flat surfaces, where a flat surface opposite to the inner peripheral surface is an outer peripheral surface 21b, the outer peripheral surface 21b is perpendicular to other two flat surfaces 21c, and the other two flat surfaces 21c are parallel to a movement direction of the shielding plate 21 (i.e., parallel to a radial direction of the extraction control opening 201). When a plurality of shielding plates 21 are located at a maximum opening position, an opening area of the extraction control opening 201 formed by inner peripheral surfaces 21a of the plurality of shielding plates 21 collectively is largest, and at this time, there may be no overlap between the plurality of shielding plates 21 in a thickness direction (parallel to an axial direction of the extraction control opening 201). During a process of the plurality of shielding plates 21 moving from the maximum opening position along the radial direction of the extraction control opening 201 toward a center of the extraction control opening 201, partial overlap is generated between the plurality of shielding plates 21 in the thickness direction to reduce the opening area of the extraction control opening 201. Further, in some embodiments, portions where each shielding plate 21 overlaps with two adjacent shielding plates 21 are respectively located at different sides of the two adjacent shielding plates 21. Specifically, as shown in FIG. 4, for every three adjacent shielding plates 21, which are a first shielding plate 21A, a second shielding plate 21B, and a third shielding plate 21C, the second shielding plate 21B is located between the first shielding plate 21A and the third shielding plate 21C, and a portion where the first shielding plate 21A overlaps with the second shielding plate 21B (i.e., a portion in a dashed box D1 in FIG. 4) is located at a side of the second shielding plate 21B close to the extraction opening 101, and a portion where the third shielding plate 21C overlaps with the second shielding plate 21B (i.e., a portion in a dashed box D2 in FIG. 4) is located at a side of the second shielding plate 21B away from the extraction opening 101. In this way, movement interference between the first shielding plate 21A and the third shielding plate 21C caused by being located at the same side of the second shielding plate 21B can be avoided.

In some embodiments, considering durability of the shielding plate 21, a thickness of the shielding plate 21 is greater than or equal to 0.5 mm.

In some embodiments, the electron beam generator further includes a mounting member, the mounting member is provided with guide grooves, shielding plates 21 are correspondingly disposed in the guide grooves, and each of the guide grooves is used to enable a corresponding shielding plate 21 to move along the radial direction of the extraction control opening 201. The guide grooves are able to play a guiding role for the shielding plates 21, so that the shielding plates 21 are able to move along the radial direction of the extraction control opening 201.

Further, in some embodiments, a cutout part communicating with the guide grooves is further formed at the mounting member, and an orthographic projection of the cutout part on a radial cross-section of the extraction opening 101 at least partially overlaps with an orthographic projection of the extraction opening 101 on the radial cross-section of the extraction opening 101. The shielding plate 21 is able to extend into the cutout part along the radial direction of the extraction control opening 201. Specifically, when each shielding plate 21 is completely retracted into a corresponding guide groove, an opening area of the extraction control opening 201 is an opening area of an overlapping region between the cutout part and the extraction opening 101. When each shielding plate 21 extends into the cutout part along the radial direction of the extraction control opening 201, the plurality of shielding plates 21 shield a peripheral region of the cutout part, and inner peripheral surfaces of the plurality of shielding plates 21 collectively form the extraction control opening 201 in the cutout part. At this time, the opening area of the extraction control opening 201 is a region of the cutout part that is not shielded by the plurality of shielding plates 21.

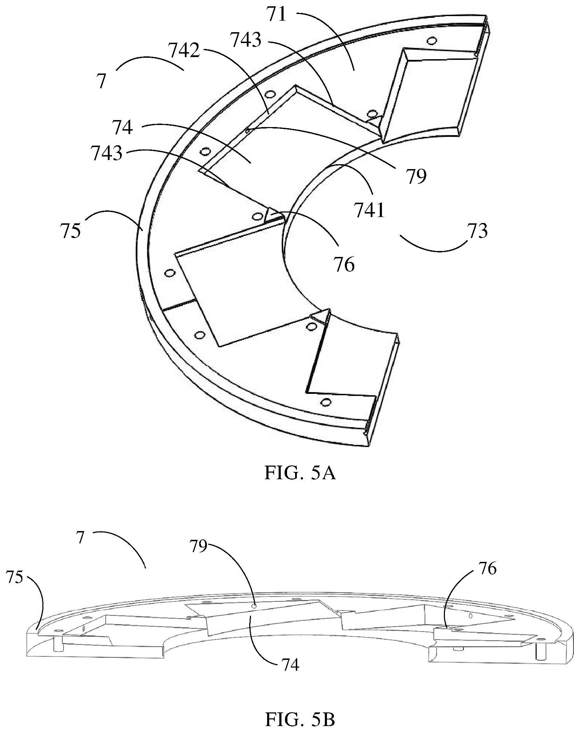

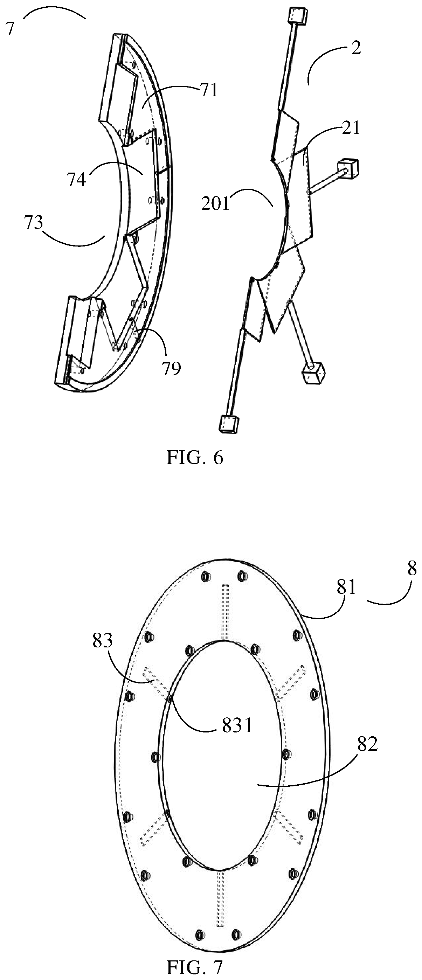

There may be a variety of structures for the mounting member implementing the above functions. In some embodiments, please refer to FIG. 5A, FIG. 5B, and FIG. 6 together; the mounting member is an annular mounting member 7, and the annular mounting member 7 is disposed at a surface of a side where an extraction opening 101 of an electron beam generation chamber 1 is located, for example, disposed at a surface of a side of a shielding chamber lid body 32 away from the electron beam generation chamber 1. An annular hole 73 of the annular mounting member 7 is the above cutout part and is coaxially arranged with the extraction opening 101, and an opening area of the annular hole 73 should be greater than or equal to a maximum opening area of the extraction control opening 201.

A plurality of guide grooves 74 arranged in sequence along a circumferential direction of the annular mounting member 7 are formed at the annular mounting member 7, and each of the guide grooves 74 has an opening 741 formed at an inner peripheral surface of the annular mounting member 7. Each shielding plate 21 is disposed in each guide groove 74 in a one-to-one correspondence, and is able to extend into the annular hole 73 via the opening 741 along a radial direction of the extraction control opening 201, and inner peripheral surfaces of each shielding plate 21 and the opening 741 both face toward the annular hole 73. Specifically, when each shielding plate 21 is completely retracted into a corresponding guide groove 74, an opening area of the extraction control opening 201 is an opening area of the annular hole 73. When each shielding plate 21 extends into the annular hole 73 via the opening 741 along the radial direction of the extraction control opening 201, the plurality of shielding plates 21 shield a peripheral region of the annular hole 73 of the annular mounting member 7, and at the same time, inner peripheral surfaces of the plurality of shielding plates 21 collectively form the extraction control opening 201 in the annular hole 73. Further, in some embodiments, a shape of an orthographic projection of the guide groove 74 on a radial cross-section of the annular mounting member 7 matches a shape of an orthographic projection of the shielding plate 21 on the radial cross-section of the annular mounting member 7; for example, the shielding plate 21 is a flat plate having four side surfaces, one of the side surfaces is the above inner peripheral surface 21a, for example, an arcuate surface, and remaining three side surfaces are all flat surfaces, where a flat surface opposite to the inner peripheral surface 21a is an outer peripheral surface 21b, the outer peripheral surface 21b is perpendicular to other two flat surfaces 21c, and the other two flat surfaces 21c are parallel to a movement direction of the shielding plate 21 (i.e., parallel to the radial direction of the extraction control opening 201). In this case, correspondingly, as shown in FIG. 5A, the guide groove 74 has three side surfaces, respectively corresponding to three side surfaces of the shielding plate 21 except for the inner peripheral surface, where one side surface 742 is opposite to the opening 741, and other two side surfaces 743 of the guide groove 74 parallel to the radial direction of the extraction control opening 201 are able to play a guiding role for the shielding plate 21, so that the shielding plate 21 is able to move along the radial direction of the extraction control opening 201.

In some embodiments, a portion of each shielding plate 21 extending into the cutout part (for example, the annular hole 73) and portions of two adjacent shielding plates 21 extending into the cutout part (for example, the annular hole 73) partially overlap in an orthographic projection on a radial cross-section of the extraction opening 101 (for example, in an axial direction of the annular mounting member 7). In this way, reducing the opening area of the extraction control opening 201 can be realized. Specifically, as shown in FIG. 5B, a bottom surface of the guide groove 74 is an inclined surface inclined corresponding to the radial cross-section of the annular mounting member 7, and a plurality of guide grooves 74 all incline toward the same direction, that is, a depth of each guide groove 74 increases from one side surface 743 toward another side surface 743. Thus, under a guiding role of the guide groove 74, a portion of the shielding plate 21 extending into the annular hole 73 is also inclined, so as to realize overlap between adjacent shielding plates 21 and avoid movement interference. Further, for two adjacent guide grooves 74, a maximum depth of one guide groove 74 is d11, and a minimum depth is d12; a maximum depth of another guide groove 74 is d21, and a minimum depth is d22. In this case, an absolute value of a difference between the minimum depth d12 of one guide groove 74 and the maximum depth d21 of the other guide groove 74 is equal to a thickness of the shielding plate 21, which can ensure that two adjacent shielding plates 21 are in contact, so that a closed extraction control opening 201 can be formed.

In some embodiments, on a side surface of each guide groove 74 corresponding to the cutout part (for example, the annular hole 73), a movement channel 79 is formed penetrating along the radial direction of the extraction control opening 201 to an outer side surface of the mounting member (for example, an outer peripheral surface of the annular mounting member 7) facing away from the side surface. Moreover, as shown in FIG. 3A and FIG. 3B, the electron beam generator further includes a plurality of connection rods 22 and a plurality of linear driving sources 23, each of the connection rods 22 is disposed through each of the movement channels 79 in a one-to-one correspondence, and one end of each of the connection rods 22 is connected to each of the shielding plates 21 in a one-to-one correspondence, and the other end is connected to each of the linear driving sources 23 in a one-to-one correspondence. Each linear driving source 23 is used to drive a corresponding shielding plate 21 to move along the radial direction of the extraction control opening 201 through a corresponding connection rod 22. The linear driving source 23 is, for example, a stepper motor, and a plurality of stepper motors are able to drive a plurality of shielding plates 21 to move synchronously.

In some embodiments, as shown in FIG. 7, the electron beam generator further includes an annular fixing member 8, and the annular fixing member 8 is fixedly connected to the annular mounting member 7 and configured to limit each shielding plate 21 in a corresponding guide groove 74. The annular fixing member 8 and the annular mounting member 7 are fixedly connected, for example, using a plurality of screws. An annular hole 82 of the annular fixing member 8 is coaxially arranged with the extraction opening 101, and an opening area of the annular hole 82 is, for example, the same as the opening area of the annular hole 73 of the annular mounting member 7.

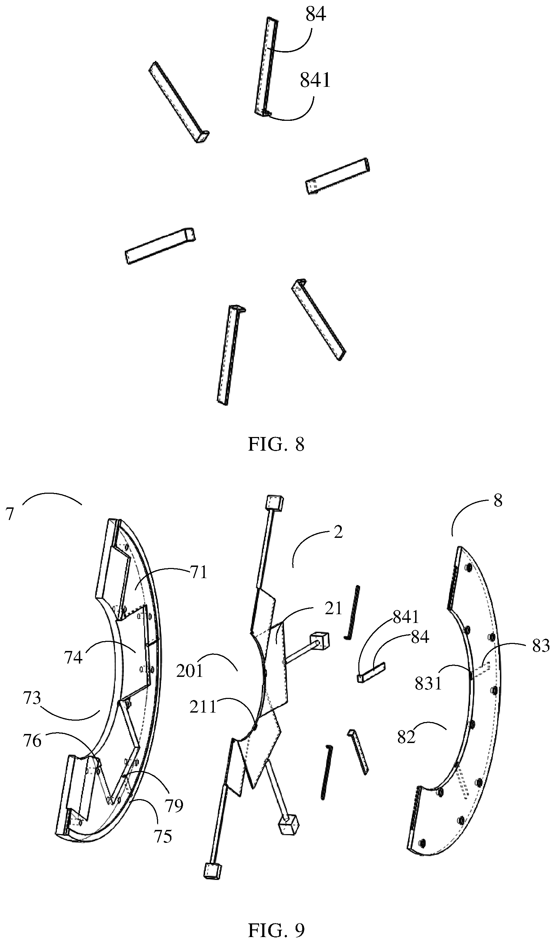

In some embodiments, a positioning structure is disposed between an annular fixing member 8 and an annular mounting member 7, and configured to define a relative position between the annular fixing member 8 and the annular mounting member 7. The positioning structure may have a variety of structures; for example, the positioning structure includes a protrusion structure formed at a surface of the annular mounting member 7 where guide grooves 74 are located (i.e., surface 71 in FIG. 5A and FIG. 6), the protrusion structure forms a positioning groove on the annular mounting member 7, and configured to define the relative position of the annular fixing member 8 at the annular mounting member 7. The present disclosure has no particular limitation on the protrusion structure, as long as defining the relative position of the annular fixing member 8 at the annular mounting member 7 is able to be realized; for example, as shown in FIG. 5A, FIG. 5B, FIG. 9, and FIG. 10, the protrusion structure includes an annular protrusion 75 disposed along an outer peripheral edge of the surface (i.e., surface 71 in FIG. 5A and FIG. 6) where the guide grooves 74 of the annular mounting member 7 are located, and a convex block 76 disposed at an inner peripheral edge of the surface (i.e., surface 71 in FIG. 5A and FIG. 6) where the guide grooves 74 of the annular mounting member 7 are located and located between every two adjacent guide grooves 74, an inner peripheral surface of the annular protrusion 75 is fitted with an outer peripheral surface of the annular fixing member 8; and a surface of the convex block 76 corresponding to the annular protrusion 75 is fitted with an inner peripheral surface of the annular fixing member 8. That is, the annular fixing member 8 is located in an annular groove formed by the annular protrusion 75 and each of the a convex block 76. A shape of the convex block 76 located between every two adjacent guide grooves 74 may match a shape of an interval between every two adjacent guide grooves 74, for example, being a triangular convex block, and located at an inner peripheral edge of the interval.

In some embodiments, please refer to FIG. 7 to FIG. 10 together, an electron beam generator further includes a plurality of limit rods 84; a plurality of limit channels 83 are formed at a surface of an annular fixing member 8 facing an annular mounting member 7 (i.e., surface 81 in FIG. 7), each of the limit channels 83 extends along a radial direction of an extraction control opening 201, and forms a channel opening 831 at an inner peripheral surface of the annular fixing member 8; each of the limit rods 84 is disposed in each of the limit channels 83 in a one-to-one correspondence, and is able to extend into an annular hole 83 of the annular fixing member 8 via the channel opening 831 along the radial direction of the extraction control opening 201; each of the limit rods 84 is stacked on a surface of each shielding plate 21 adjacent to the annular fixing member 8 in a one-to-one correspondence, and an end of each of the limit rods 84 facing the channel opening 831 is fixedly connected to an inner peripheral edge of a corresponding shielding plate 21. When the shielding plate 21 moves along the radial direction of the extraction control opening 201, since each of the limit rods 84 is fixedly connected to the corresponding shielding plate 21, the limit rod 84 will slide along the limit channel 83 under the drive of the shielding plate 21. By means of the limit rod 84, the position of the corresponding shielding plate 21 can be limited, so as to avoid tilting of the shielding plate 21.

There may be a variety of ways for each limit rod 84 to be fixedly connected to a corresponding shielding plate 21. In some embodiments, an end of each limit rod 84 facing a channel opening 831 is provided with a bent member 841 bent in a direction approaching the shielding plate 21; a fixing hole 211 is formed at an inner peripheral edge of a surface of each shielding plate 21 adjacent to an annular fixing member 8; and the bent member 841 of each of the limit rods 84 is disposed in the fixing hole 211 of each of the corresponding shielding plates 21. In this way, installation and disassembly of the limit rod 84 can be facilitated.

In some embodiments, as shown in FIG. 1, a shielding assembly 2 is disposed between an electron beam generation chamber 1 and an extraction electrode 6, and both an annular mounting member 7 and an annular fixing member 8 are made of insulating materials, and used to electrically insulate the electron beam generation chamber 1 from the extraction electrode 6. In this way, the extraction electrode 6 can be arranged at a surface of a side of the annular fixing member 8 away from the annular mounting member 7 (i.e., a surface opposite surface 81 in FIG. 7), thereby facilitating installation of the extraction electrode 6. In addition, the shielding plate 21 may adopt an insulating material, or may also adopt a metal material.

In summary, the electron beam generator provided in the present disclosure can adjust an extraction area of an extraction opening of an electron beam generation chamber through a shielding assembly. During a process of electron movement, by controlling the shielding assembly to adjust the extraction area of the extraction opening according to a magnitude of a plasma density value inside the electron beam generation chamber, the extraction area can be enabled to adapt to a plasma sheath morphology change, so that electron extraction efficiency is always maintained at a relatively large value, thereby effectively improving performance and stability of the electron beam generator.

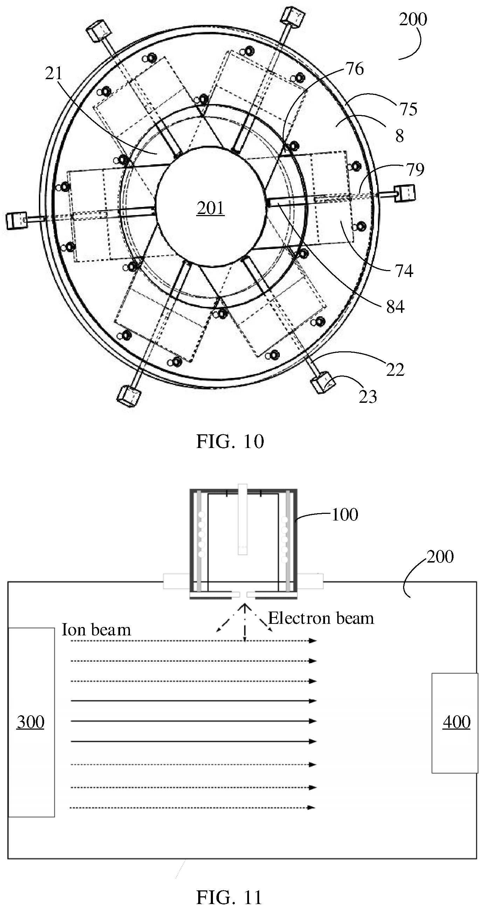

As another technical solution, please refer to FIG. 11, embodiments of the present disclosure further provide ion beam etching equipment, including a process chamber 200, and an ion source generation device 300 and a carrier device 400 oppositely disposed in the process chamber 200 along a first direction, the ion source generation device 300 is used to generate an ion beam and extract ion beam into the process chamber 200 along the first direction, so that the ion beam is able to move toward the carrier device 400 on an opposite side. The carrier device 400 is used to carry a wafer, and may also be used to load RF power to the wafer.

The ion beam etching equipment further includes the above electron beam generator 100 provided in the present disclosure, the electron beam generator 100 is disposed at a chamber body of the process chamber 200, and an extraction opening of an electron beam generation chamber communicates with the process chamber 200 and faces toward a second direction, and configured to extract an electron beam into the process chamber 200. The above second direction is at an angle with the first direction, for example, at a 90° angle. Specifically, the above first direction is, for example, a horizontal direction, and the second direction is a vertical direction.

In some embodiments, a sensor and a controller are further included, the sensor is used to obtain a plasma density in an electron beam generation chamber, and the controller is used to, according to the plasma density obtained by the sensor, control the electron beam generator 100 to adjust an extraction area of an extraction opening.

The above controller is further used to control operation of the electron beam generator 100. Taking the electron beam generator 100 shown in FIG. 1 as an example, a specific control method of the controller includes: controlling a corresponding gas supply device to introduce inert gas into an interior of an electron beam generation chamber 1 through an intake channel in an ion collector 5; then, controlling an RF source to turn on to load RF power to an RF coil 4, so as to excite the inert gas inside the electron beam generation chamber 1 to form plasma, and electrons in the plasma, under action of a space electric field formed between the ion collector 5 and an extraction electrode 6, move from an electron extraction opening 101 to the outside of the electron beam generation chamber 1 and enter the process chamber 200. Moreover, during a process of electron movement, the controller controls a shielding assembly 2 in the electron beam generator 100 to adjust an extraction area of an extraction opening according to a magnitude of a plasma density value inside the electron beam generation chamber 1. In this way, the extraction area of the extraction opening can be enabled to adapt to a plasma sheath morphology change, so that electron extraction efficiency is always maintained at a relatively large value, thereby effectively improving performance and stability of the electron beam generator.

The ion beam etching equipment provided in the present disclosure, by adopting the above electron beam generator provided in the present disclosure, can cause electron extraction efficiency to be always maintained at a relatively large value, thereby being able to optimize a process performance.

It can be understood that the above embodiments are merely exemplary embodiments adopted to illustrate the principles of the present disclosure; however, the present disclosure is not limited thereto. For those of ordinary skill in the art, various modifications and improvements can be made without departing from the spirit and essence of the present disclosure, and these modifications and improvements are also regarded as the scope of the present disclosure.

## Claims

1. An electron beam generator, comprising:
an electron beam generation chamber having an extraction opening;
a shielding assembly, movably disposed outside the electron beam generation chamber, the shielding assembly being configured to shield the extraction opening, and an extraction area of the extraction opening being able to be adjusted by adjusting a position of the shielding assembly.

2. The electron beam generator according to claim 1, wherein the shielding assembly includes a plurality of shielding plates arranged in sequence in a circumferential direction, inner peripheral surfaces of the plurality of shielding plates collectively form an extraction control opening, and the extraction control opening is disposed corresponding to the extraction opening;
the plurality of shielding plates are all able to move along a radial direction of the extraction control opening, and collectively form the extraction control opening with different opening areas at different positions in the radial direction of the extraction control opening.

3. The electron beam generator according to claim 2, wherein the extraction control opening is coaxial with the extraction opening.

4. The electron beam generator according to claim 2, wherein the electron beam generator further includes a mounting member, the mounting member is provided with guide grooves, the shielding plates are correspondingly disposed in the guide grooves, and each of the guide grooves is configured to enable a corresponding shielding plate to move along the radial direction of the extraction control opening.

5. The electron beam generator according to claim 4, wherein a cutout part communicating with the guide grooves is further formed at the mounting member, and an orthographic projection of the cutout part on a radial cross-section of the extraction opening at least partially overlaps with an orthographic projection of the extraction opening on the radial cross-section of the extraction opening;
the shielding plate is able to extend into the cutout part along the radial direction of the extraction control opening.

6. The electron beam generator according to claim 5, wherein the mounting member is an annular mounting member, and an annular hole of the annular mounting member is coaxially arranged with the extraction opening;
each of the guide grooves has an opening formed at an inner peripheral surface of the annular mounting member, each of the shielding plates is able to extend into the annular hole via the opening along the radial direction of the extraction control opening, and the inner peripheral surface of each of the shielding plates and the opening both face toward the annular hole.

7. The electron beam generator according to claim 5, wherein an orthographic projection of a portion of each shielding plate extending into the cutout part on the radial cross-section of the extraction opening partially overlaps with orthographic projections of portions of two adjacent shielding plates extending into the cutout part on the radial cross-section of the extraction opening.

8. The electron beam generator according to claim 7, wherein overlapping portions of each shielding plate and two adjacent shielding plates are respectively located at different sides of the two adjacent shielding plates.

9. The electron beam generator according to claim 5, wherein a movement channel is formed at a side surface of each of the guide grooves corresponding to the cutout part, the movement channel penetrating along the radial direction of the extraction control opening to an outer side surface of the mounting member facing away from the side surface;
the electron beam generator further includes a plurality of connection rods and a plurality of linear driving sources, each of the connection rods is disposed through each of the movement channels in a one-to-one correspondence, and one end of each of the connection rods is connected to each of the shielding plates in a one-to-one correspondence, and another end is connected to each of the linear driving sources in a one-to-one correspondence; and each of the linear driving sources is configured to drive a corresponding shielding plate to move along the radial direction of the extraction control opening through a corresponding connection rod.

10. The electron beam generator according to claim 6, wherein the electron beam generator further includes an annular fixing member, and the annular fixing member is fixedly connected to the annular mounting member and configured to limit each of the shielding plates in a corresponding guide groove.

11. The electron beam generator according to claim 10, wherein a positioning structure is disposed between the annular fixing member and the annular mounting member, and configured to define a relative position between the annular fixing member and the annular mounting member.

12. The electron beam generator according to claim 11, wherein the positioning structure includes a protrusion structure formed at a surface of the annular mounting member where the guide grooves are located, and the protrusion structure forms a positioning groove on the annular mounting member, and configured to define the relative position of the annular fixing member on the annular mounting member.

13. The electron beam generator according to claim 12, wherein the protrusion structure includes an annular protrusion disposed along an outer peripheral edge of the surface of the annular mounting member where the guide grooves are located, and a convex block disposed at an inner peripheral edge of the surface of the annular mounting member where the guide grooves are located and located between every two adjacent guide grooves, an inner peripheral surface of the annular protrusion is fitted with an outer peripheral surface of the annular fixing member, and a surface of the convex block corresponding to the annular protrusion is fitted with an inner peripheral surface of the annular fixing member.

14. The electron beam generator according to claim 10, wherein the electron beam generator further includes a plurality of limit rods;
a plurality of limit channels are formed at a surface of the annular fixing member facing the annular mounting member, each of the limit channels extends along the radial direction of the extraction control opening, and a channel opening is formed at an inner peripheral surface of the annular fixing member; each of the limit rods is disposed in each of the limit channels in a one-to-one correspondence, and is able to extend into an annular hole of the annular fixing member via the channel opening along the radial direction of the extraction control opening;
each of the limit rods is stacked on a surface of each of the shielding plates adjacent to the annular fixing member in a one-to-one correspondence, and an end of each of the limit rods facing the channel opening is fixedly connected to an inner peripheral edge of a corresponding shielding plate.

15. The electron beam generator according to claim 14, wherein an end of each of the limit rods facing the channel opening is provided with a bent member bent in a direction approaching the shielding plate, a fixing hole is formed at an inner peripheral edge of a surface of each of the shielding plates adjacent to the annular fixing member;
the bent member of each of the limit rods is disposed in the fixing hole of each of the corresponding shielding plates.

16. Ion beam etching equipment, comprising a process chamber, and an ion source generation device and a carrier device oppositely disposed in the process chamber along a first direction, wherein the ion beam etching equipment further includes the electron beam generator according to any one of claims 1 to 15, the electron beam generator is disposed at a chamber body of the process chamber, and the extraction opening communicates with the process chamber and faces toward a second direction, and configured to extract an electron beam into the process chamber, the second direction being at an angle with the first direction.

17. The ion beam etching equipment according to claim 16, wherein a sensor and a controller are further included, the sensor is configured to obtain a plasma density in the electron beam generation chamber, and the controller is configured to, according to the plasma density obtained by the sensor, control the shielding assembly in the electron beam generator to adjust the extraction area of the extraction opening.
